## Europäisches Patentamt
## European Patent Office
## Office européen des brevets

(19)

(11) Veröffentlichungsnummer: **0 065 665**

**A1**

(12)

# EUROPÄISCHE PATENTANMELDUNG

(21) Anmeldenummer: **82103690.2**

(22) Anmeldetag: **30.04.82**

(51) Int. Cl.³: **G 06 F 5/00**
**H 04 L 25/16**

(30) Priorität: **12.05.81 DE 3118676**

(43) Veröffentlichungstag der Anmeldung:
**01.12.82 Patentblatt 82/48**

(84) Benannte Vertragsstaaten:
**AT BE CH DE FR GB IT LI LU NL SE**

(71) Anmelder: **Heinz, Karl Eckhardt, Dr.**
**Niebuhrstrasse 49**
**D-5300 Bonn 1(DE)**

(72) Erfinder: **Heinz, Karl Eckhardt, Dr.**
**Niebuhrstrasse 49**
**D-5300 Bonn 1(DE)**

(74) Vertreter: **Blumbach Weser Bergen Kramer Zwirner**
**Hoffmann Patentanwälte**
**Sonnenbergerstrasse 43**
**D-6200 Wiesbaden 1(DE)**

(54) Verfahren zur Kompression redundanter Folgen serieller Datenelemente.

(57) Es wird ein Verfahren zur Kompression redundanter Folgen serieller Datenelemente beschrieben, die in Teilfolgen mit je beliebiger Anzahl von Datenelementen und ein Schlußzeichen unterteilt sind, sowie ein Verfahren zur Dekompression derart komprimierter Folgen. Das Verfahren läßt sich auf einfache Weise automatisch, d.h. maschinell anwenden, und zwar insbesondere bei Datenfolgen, die in hohem Maße redundant sind, beispielsweise Fernsehbilder, sprachliche Texte und anderes. Bei dem Verfahren werden jeweils Elemente zu Zweiergruppen zusammengefaßt, die dann eine Codebezeichnung erhalten. Die Codebezeichnung wird wiederum als Element aufgefaßt und dann mit den weiteren Elementen verarbeitet. Die Ergebnisse speichert man in Listen, die eine wesentlich kleinere Zahl von Elementen wie die ursprünglichen Datenfolgen enthalten und demgemäß weniger redundant sind.

EP 0 065 665 A1

**BLUMBACH · WESER · BERGEN · KRAMER**
**ZWIRNER · HOFFMANN**
PATENTANWÄLTE IN MÜNCHEN UND WIESBADEN

Patentconsult Radeckestraße 43 8000 München 60 Telefon (089) 883603/883604 Telex 05-212313 Telegramme Patentconsult
Patentconsult Sonnenberger Straße 43 6200 Wiesbaden Telefon (06121) 562943/561998 Telex 04-186237 Telegramme Patentconsult

– 1 –

Dr. Karl Eckhart Heinz
Niebuhrstraße 49
5300 Bonn 1


Verfahren zur Kompression redundanter Folgen serieller

Datenelemente


Die Erfindung betrifft ein Verfahren zur Kompression redundanter Folgen serieller Datenelemente, die in Teilfolgen mit je beliebiger Anzahl von Datenelementen und einem Schlußzeichen unterteilt sind, sowie ein Verfahren zur Dekompression von derart komprimierten Folgen serieller Datenelemente.

Nachrichten und speziell Datenfolgen sind häufig in hohem Maße redundant, d.h. sie enthalten eine wesentlich größere Zahl von Datenelementen oder Zeichen, als es zur Darstellung der jeweils enthaltenen Information erforderlich wäre. Ein Beispiel hierfür ist die Übertragung von Fernsehbildern, bei denen die nacheinander aufgenommenen und dann gespeicherten oder übertragenen Teilbilder bezüglich derjenigen Bereiche einer Szene identisch sind, die keine Änderung hinsichtlich der Lage, Helligkeit oder Farbe der Bildpunkte erfahren ha-

München: R. Kramer Dipl.-Ing. · W. Weser Dipl.-Phys. Dr. rer. nat. · E. Hoffmann Dipl.-Ing.
Wiesbaden: P. G. Blumbach Dipl.-Ing. · P. Bergen Prof. Dr. jur. Dipl.-Ing., Pat.-Ass., Pat.-Anw. bis 1979 · G. Zwirner Dipl.-Ing. Dipl.-W.-Ing.

- 2 -

ben. Das ist im allgemeinen für den größten Teil aller Bildpunkte der Fall. Daher wird bei einem bekannten Verfahren zur Redundanzverringerung bei Fernsehbildern die Übertragung von Signalen auf diejenigen Bildpunkte oder Gruppen von Bildpunkten beschränkt, bei denen zwischen den Teilbildern eine Änderung eingetreten ist.

Auch sprachliche Texte sind in hohem Maße redundant, denn sie verwenden u.a. Einheiten eines Lexikons, die sehr häufig aus gleichen Teilfolgen kleinerer Einheiten (z.B. Buchstaben) zusammengesetzt sind.

Der Erfindung liegt nun die Aufgabe zugrunde, ein Verfahren anzugeben, mit dem sich auf einfache Weise und automatisch, d.h. maschinell, die Redundanz in Folgen serieller Datenelemente, die in Teilfolgen mit je beliebiger Anzahl von Datenelementen und einem Schlußzeichen unterteilt sind, verringern läßt, derart, daß die Verarbeitung und insbesondere Speicherung und Übertragung derart komprimierter Folgen vereinfacht wird.

Die Lösung der Aufgabe ist im Anspruch 1 angegeben. Anspruch 2 beinhaltet das Verfahren zur Dekompression einer gemäß Anspruch 1 komprimierten Folge serieller Datenelemente.

Unter "Folgen serieller Datenelemente" werden im Rahmen der Erfindung alle Arten solcher Folgen verstanden, beispielsweise die nacheinander abgetasteten bzw. wiedergegebenen Bildpunkte von Fernsehbildern, Buchstaben, Ziffern, ...ichen

von Sprache oder Texten sowie auch andere Folgen von Datenelementen oder Informationseinheiten. Typische Beispiele für
"Teilfolgen" sind die Zeilen eines Fernsehbildes, die eine
vorgegebene Anzahl von Datenelementen in Form von Bildpunkten enthalten, oder Texte, deren Wörter mit je einer Anzahl
von Datenelementen in Form von Buchstaben, Ziffern, Zeichen
die Teilfolgen bilden. Das "Schlußzeichen" grenzt die einzelnen Teilfolgen gegeneinander ab. Es kann entweder ein besonderes Zeichen des benutzten Zeichenvorrats sein, aber auch aus
einer Zeichenfolge bestehen oder sogar einfach nur ein Leerraum oder eine Lücke zwischen den Teilfolgen sein.

Die nach dem erfindungsgemäßen Verfahren abgeleiteten und
gespeicherten Listen nehmen für eine vorgegebene Folge serieller Datenelemente, beispielsweise für einen bestimmten
Text, nur einen wesentlich geringeren Speicherraum ein als
die Datenfolge selbst. Das gilt dann, wenn lange redundante
Datenfolgen verarbeitet werden.So werden beispielsweise bei
einem längeren Text schon
nach kurzer Zeit praktisch alle Datenelemente (Buchstaben und
Zeichen) und praktisch alle Teilfolgen (Wörter) aufgetreten
sein, so daß die weitere Verarbeitung nur noch zu einer geringfügigen Erweiterung der Gruppenliste mit einer einzelnen Eintragung in der komprimierten Liste führt.

Bei der Übertragung von Datenfolgen können entweder die nach
dem erfindungsgemäßen Verfahren erstellten Listen übertragen werden, aber es besteht auch die Möglichkeit, für einen
bestimmten Typ von Datenfolgen, beispielsweise Texte der

-4-

deutschen Sprache, jeweils anhand eines Lexikons der Teilfolgen (Wörter) eine Gruppenliste einmalig zu erstellen, die dann sende- und empfangsseitig zur Verfügung steht, so daß nur die komprimierte Liste für bestimmte Texte übertragen werden muß. Gleiches gilt für das Speichern von Datenfolgen.

Weiterbildungen der Erfindung sind Gegenstand der Unteransprüche. So kann eine Gruppenliste mit dreistelligen Gruppen verwendet werden, wobei jeweils der Index der dritten Stelle jeder Gruppe die Codebezeichnung dieser Gruppe ist. Die zugehörigen Verfahrensschritte dieser Weiterbildung sind im Anspruch 3 angegeben. Anspruch 4 enthält die zugehörigen Verfahrenschritte für die Dekompression.

Eine Vereinfachung der Gruppenliste für Suchvorgänge ergibt sich dann, wenn der Eintrag eines folgenden Elements an der zweiten Stelle einer Gruppe nur dann erfolgt, wenn dieses Element nicht bereits an der ersten oder zweiten Stelle einer vorhergehenden Gruppe eingetragen ist. Für diesen Fall wird anstelle des Elements nur der Index des vorherigen Eintrags benutzt (Anspruch 5). Desweiteren besteht die Möglichkeit, nach dem Eintrag des Index der dritten Stelle einer Gruppe an der ersten Stelle einer weiteren Gruppe zu prüfen, ob dieser Index bereits an der ersten Stelle einer vorhergehenden Gruppe eingetragen ist, und dann gegebenenfalls den vorhergehenden Eintrag zu ersetzen (Anspruch 7).

-5-

Eine zusätzliche Weiterbildung der Erfindung sieht vor, daß nicht die Elemente einer Folge selbst in die Gruppenliste eingetragen werden, sondern daß zur Vereinfachung von Bezugnahmen und Suchvorgängen die Datenelemente jeweils bei ihrem ersten Auftreten zunächst in eine besondere Zeichenliste eingetragen werden und ihnen dort ein Code in Form des Zeichenlistenindex zugeordnet wird, der dann in der Gruppenliste oder auch der komprimierten Datenfolgeliste verwendet wird. Außerdem enthält die Zeichenliste für jedes Datenelement den jeweiligen Index der Gruppenliste bzw. der komprimierten Datenfolgeliste für das erste Auftreten des Elements. Im einzelnen sind die Verfahrensschritte der zugehörigen Weiterbildung der Erfindung in Anspruch 9 angegeben. Anspruch 10 enthält das zugehörige Verfahren zur Dekompression.

Die oben beschriebenen Möglichkeiten zur Vereinfachung der Gruppenliste lassen sich auch hier anwenden(Anspr. 11-14).

Eine Möglichkeit zur Reduzierung der Gruppenlisten besteht darin, daß anstelle einer Gruppenliste mit dreistelligen Gruppen nur eine solche mit zweistelligen Gruppen benutzt wird, wobei statt des Indexes der dritten Stelle als Codebezeichnung für die jeweils vorhergehende Gruppe der Index der ersten Stelle jeder nachfolgenden Gruppe als Codebezeichnung für die jeweils unmittelbar vorhergehende Gruppe verwendet wird. Die Verfahrenschritte dazu sind im Anspruch 15 angegeben, wobei Anspruch 16 das zugehörige Dekompressionsverfahren enthält. Wiederum können die bereits erläuterten Möglichkeiten zur Vereinfachung der Gruppenliste benutzt werden (Anspr. 17-20). Auch die zusätzliche Erstellung einer Zeichenliste und Ersatz der Datenelemente in der Gruppenliste und der komprimierten Datenfolgeliste ist wiederum möglich (Anspr. 21, 22).

Zur Vereinfachung von Suchvorgängen in der komprimierten Datenfolgeliste sieht eine Weiterbildung der Erfindung vor, daß ähnlich wie bei den Eintragungen in der Gruppenliste nach Eintrag einer Codebezeichnung in die komprimierte Datenfolgeliste geprüft wird, ob diese Codebezeichnung bereits an einer vorhergehenden Stelle eingetragen ist. Wenn dies der Fall ist, wird der vorhergehende Eintrag durch den Index der gerade betrachteten Stelle ersetzt.

Wenn bei zeilenmäßig unterteilten Texten jeweils der Zeilensprung nach einer bestimmten Anzahl von Wörtern bzw. Elementen erfaßt werden soll, so sieht eine Weiterbildung der Erfindung vor, daß jeweils die Codebezeichnung der das letzte Element einer Zeile enthaltenden Gruppe ein negatives Vorzeichen erhält.

Ein problemloses Erweitern oder Aneinanderreihen von Speichern wird in Weiterbildung der Erfindung dadurch erzielt, daß die zur Ablage der Listen verwendeten Speicher sich sequentiell aneinander anschließen und daß Verweise in den Listen, die zu einer Stelle jenseits des unmittelbar folgenden Speichers oder zu einer höheren Stelle des unmittelbar folgenden Speichers führen, mit einer Kennzeichnung versehen werden. Diese Kennzeichnung, die im einfachsten Fall ein negatives Vorzeichen und der Verweis auf eine besondere Liste sein kann, veranlaßt dann als weiteren Verfahrensschritt die Abfrage der besonderen Liste, in welcher die jeweilige Speicherzugehörigkeit und Speicherstelle angegeben ist. Diese Weiterbildung gilt für Verweise in allen erläuterten Listen, also den Zeichen-, Gruppen- und komprimierten Datenfolgelisten. Da in allen Fällen die Verweise immer zu höheren Stellen führen, ist eine Kennzeichnung bei einem Verweis zu einer niedrigeren Stelle im unmittelbar anschließenden Speicher nicht erforderlich.

Eine Weiterbildung der Erfindung (Anspruch 30) ist auf eine besonders zweckmäßige Anwendung des erfindungsgemäßen Verfahrens gerichtet, die die automatische Verknüpfung solcher Folgen serieller Datenelemente betrifft und dadurch gekennzeichnet ist, daß die Knotenpunkte der Verknüpfung durch identische Teilfolgen gebildet werden. Die identischen Teilfolgen lassen sich in den zugehörigen komprimierten Datenfolgelisten der zu verknüpfenden Folgen feststellen.

Dabei kann zur Herstellung einer Verbindung zwischen einem Anfangspunkt, der sich in einer ersten Folge befindet, und einem Zielpunkt, der sich in einer zweiten Folge befindet, eine identische Teilfolge in den komprimierten Datenfolgelisten der beiden Folgen gesucht werden. Das setzt das Vorhandensein eines Knotenpunktes zwischen den beiden Folgen voraus. Wenn in weiterer Ausbildung eine Verbindung zwischen einem Ausgangspunkt, der sich in einer ersten Folge befindet, und einem Zielpunkt hergestellt werden soll, der sich in einer nicht direkt mit der ersten Folge verknüpften zweiten Folge befindet, so werden die komprimierte Datenfolgeliste der ersten und der zweiten Folge je mit den komprimierten Datenfolgelisten weiterer Folgen verglichen, um einen geschlossenen Verbindungsweg über identische Teilfolgen von je zwei direkt miteinander verknüpften Folgen zu finden. Die Suche läßt sich dadurch noch wesentlich vereinfachen, wenn in weiterer Ausbildung die Knotenpunkte in einer gesonderten Liste gespeichert sind.

Die vorstehend beschriebenen Anwendungen können beispielsweise zur Ermittlung von Verbindungen in einem Transportnetz, beispielsweise dem Schienennetz dienen. Direkte Verbindungen zwischen einem Ausgangspunkt und einem Zielpunkt, also beispielsweise zwischen zwei Bahnhöfen auf der gleichen Strecke lassen sich dann dadurch finden, daß die beiden Punkte in der gleichen Folge von seriellen Datenelementen liegen, wobei die Teilfolgen beispielsweise Bahnhofsnamen in einem Fahrplan als Text darstellen. Bei einem Transportmittelwechsel ("Umsteigen") ergeben sich die Teilverbindungen durch die Knotenpunkte miteinander verknüpfter Folgen, beispielsweise der Fahrpläne für sich kreuzende Strecken mit Umsteigebahnhöfen. Den gespeicherten Daten können dabei jeweils weitere Daten zugeordnet sein, beispielsweise Entfernungskilometer, Zeitangaben für Ankunft und Abfahrt (Fahrplan) usw.. Auf diese Weise können Auskünfte über bestehende Verbindungsmöglichkeiten zwischen beliebigen Punkten eines Netzes schnell und ohne großen Rechen- und Speicheraufwand gegeben werden.

Nachfolgend werden die Verfahren nach der Erfindung anhand einfacher Beispiele erläutert. Es wird dabei jeweils ausgegangen von einer Datenfolge, die die beiden Wörter "ABER" und "ABEND" mit jeweils einem Schlußzeichen (*) seriell enthält.

Tabelle 1 zeigt diese ursprüngliche Datenfolgeliste.

Tabelle 1

Datenfolgeliste

| Indes | Element |
|-------|---------|
| 1 | A |
| 2 | B |
| 3 | E |
| 4 | R |
| 5 | * |
| 6 | A |
| 7 | B |
| 8 | E |
| 9 | N |
| 10 | D |
| 11 | * |

Entsprechend den in Anspruch 3 im einzelnen angegebenen Verfahrensschritten werden die in Tabellen 2 und 3 gezeigte Gruppenliste I und komprimierte Liste I erstellt.

## Tabelle 2

### Gruppenliste I

| Index | Eintrag |
|-------|---------|
| 100 | A |
| 101 | B |
| 102 | 103 |
| 103 | 102 |
| 104 | E |
| 105 | 106 |
| 106 | 105 (112) |
| 107 | R |
| 108 | 109 |
| 109 | 108 |
| 110 | * (119) |
| 111 | 1000 |
| 112 | 105 |
| 113 | N |
| 114 | 115 |
| 115 | 114 |
| 116 | D |
| 117 | 118 |
| 118 | 117 |
| 119 | * |
| 120 | 1001 |

## Tabelle 3

### Komprimierte Liste I

| Index | Eintrag |
|-------|---------|
| 1000 | 111 |
| 1001 | 120 |

Für die erste Teilfolge, d.h. das erste Wort "ABER*", wird also gemäß Schritt 1 zunächst das erste Element A an die Stelle mit dem Index 100 der Gruppenliste I eingetragen, wobei die erste dreistellige Gruppe die drei Stellen 100, 101, 102 umfaßt. Gemäß Schritt 2 wird dann das zweite Element B an der zweiten Stelle 101 eingetragen. Schritt 3 führt zum Eintrag des Index 102 der dritten Stelle als Codebezeichnung der Gruppe an der ersten Stelle 103 der zweiten Gruppe. Der Index 103 dieser ersten Stelle wird dann gemäß Schritt 4 an die dritte Stelle 102 der ersten Gruppe eingetragen. Anschließend wird das folgende Element E in die zweite Stelle 104 der zweiten Gruppe eingetragen, und dann erfolgt wiederum gemäß Schritt 6 die Eintragung des Index 105 der dritten ruppenstelle an die erste Stelle 106 der dritten Gruppe. Die Klammerangabe 112 bleibt zunächst unbeachtet. Nachdem wiederum entsprechend Schritt 7 der Index 106 der ersten Stelle an die dritte Stelle 105 der zweiten Gruppe eingetragen worden ist, wiederholt man die Verfahrensschritte 5 bis 7 für die weiteren Elemente E, R, * des ersten Wortes ABER*. Dann ist zuletzt das Schlußzeichen * an der Stelle 110 eingetragen worden. Wiederum bleibt die Klammerangabe 119 zunächst unbeachtet. Gemäß Schritt 9 trägt man dann den Index 111 für die dritte Stelle der zugehörigen Gruppe an der ersten Stelle 1000 der komprimierten Liste I gemäß Tabelle 3 ein.

Für die weitere Teilfolge, also das Wort "ABEND*", werden dann die weiteren Verfahrensschritte 10 bis 16 gemäß Anspruch 3 durchgeführt. Zunächst ergibt die Prüfung gemäß Schritt 10, daß die erste Gruppe 100 bis 102 in der Gruppenliste das erste Element A an der ersten Stelle 100 und das zweite Element B an der zweiten Stelle 101 enthält. Demgemäß ist zum Schritt 12 überzugehen. Man stellt fest, daß der gefundenen Gruppe 100 bis 102 eine Gruppe 103 bis 105 folgt, die an der zweiten Stelle 104 das folgende Element E von ABEND enthält. Daher ist zum Schritt 14 weiterzugehen. Hier ergibt die Prüfung, daß in diesem Fall der Gruppe 103 bis 105 nicht eine Gruppe folgt, die an der zweiten Stelle das folgende Element N enthält. Vielmehr enthält die folgende Gruppe 106 bis 108 an der zweiten Stelle das Element R. Daher ist jetzt der Schritt 15 durchzuführen. Zunächst wird also gemäß

-12-

Schritt 6 der Index 105 der dritten Gruppenstelle als Codebezeichnung an die erste Stelle 112 einer weiteren Gruppe 112
bis 114 eingetragen. Die Durchführung der weiteren Schritte
8 und 9 führt dann zu den angegebenen Eintragungen der
Gruppenliste sowie der Eintragung des Index 120 an die
zweite Stelle 1001 der komprimierten Liste I.

Die Dekompression läßt sich anhand der Verfahrensschritte
gemäß Anspruch 4 und der Tabellen 2 und 3 leicht verfolgen.
Nach Aufruf des ersten Eintrags 111 der komprimierten Datenfolgeliste ergibt die Prüfung gemäß Schritt 2, daß der aufgerufene Eintrag ein Index für die dritte Stelle der Gruppe
109 bis 111 in der Gruppenliste ist. Die weitere Prüfung
gemäß Schritt 3 zeigt, daß der Eintrag 108 an der ersten
Stelle der Gruppe wieder der Index für die dritte Stelle
der vorhergehenden Gruppe 106 bis 108 ist. Durch zweifache
Wiederholung der Prüfung mit gleichem Ergebnis gelangt man
zur ersten Gruppe 100 bis 102, für die der Eintrag an der
ersten Stelle das Element A ist. Durch Ausgabe des Eintrags
A und B der ersten bzw. zweiten Stelle der Anfangsgruppe und
der zweiten Stelle 104, 107, 110 aller vorhergehend durchlaufenen Gruppen erhält man das ursprüngliche Wort "ABER*".
Es bleiben wiederum die Klammerangaben zunächst unberücksichtigt.

Für den zweiten Eintrag 120 in der komprimierten Liste ergibt
die Prüfung gemäß Schritt 2 wiederum, daß es sich um den
Index für die dritte Stelle der Gruppe 118 bis 120 in der
Gruppenliste handelt. Auch die nächste Prüfung gemäß Schritt 3 zeigt, daß der Eintrag 117 an der ersten Stelle dieser Gruppe der Index der dritten Stelle der vorhergehenden Gruppe 115 bis 117 ist. Gleiches gilt für die nächste Prüfung gemäß Schritt 3, denn der Eintrag 114 an der Stelle 115 ist wiederum der Index für die dritte Stelle der Gruppe 112 bis 114. Auch die nächste Prüfung gemäß Schritt 3 ergibt, daß der Eintrag 105 an der ersten Stelle 112 der Index für die dritte Stelle der vorhergehenden Gruppe 103 bis 105 ist. Gleiches gilt für die weitere Prüfung, die zur Anfangsgruppe 100 bis 102 führt. Es folgt dann wiederum die Ausgabe der beiden Elemente A, B der Anfangsgruppe sowie der zweiten Elemente E, N, D, * der Gruppen 103 bis 105, 112 bis 114, 115 bis 117 und 118 bis 120.

Die Weiterbildung der Erfindung gemäß Anspruch 5 bewirkt, daß nach Eintrag des Elements * an der zweiten Stelle 119 der Gruppe 118 bis 120 festgestellt wird, daß dieses Element bereits an der zweiten Stelle 110 der Gruppe 109 bis 111 eingetragen ist. Die frühere Eintragung wird dann durch den Index 119 der zweiten Eintragung ersetzt, so daß dann an der Stelle 110 jetzt die Klammerangabe 119 gilt. Bei der Dekompression ergibt dann die Prüfung gemäß Anspruch 6 für die zweite Stelle 110 der Gruppe 109 bis 111, daß der Eintrag 119 der Index für die zweite Stelle der Gruppe 118 bis 120 ist, so daß dann das Element * ausgegeben wird.

Die Weiterbildung gemäß Anspruch 7 führt zum Ersatz des Eintrags 105 an der Stelle 106 durch den Index 112, so daß dann auch hier die Klammerangabe gilt. Bei der Dekompression wird dann gemäß Anspruch 8 verfahren.

Tabelle 4 zeigt die Zeichenliste für das Ausführungsbeispiel der Erfindung, bei dem gemäß Anspruch 9 anstelle der Elemente jeweils der Index der Zeichenliste in eine Gruppenliste II gemäß Tabelle 5 eingetragen werden. Die einzelnen Verfahrensschritte lassen sich anhand von Anspruch 9 leicht verfolgen. Die zugehörige komprimierte Datenfolgeliste ist wiederum die Liste gemäß Tabelle 3. Die zugehörigen Verfahrensschritte für die Dekompression finden sich in Anspruch 10. In der Gruppenliste II gelten zunächst an den Stellen 106 und 110 wiederum die nicht in Klammern stehenden Angaben. Die Weiterbildungen gemäß Anspruch 11 bzw. 13 führen dann zur Eintragung der Klammerangaben.

Durch die Zeichenliste gemäß Tabelle 4 werden Suchvorgänge zur Auffindung bestimmter Stichworte wesentlich erleichtert, weil die Elemente nicht verstreut in der Gruppenliste, sondern zusammengefaßt in der kurzen Zeichenliste stehen. Die zugehörigen Eintragungen der jeweiligen Stelle in der Gruppenliste bzw. der komprimierten Datenfolgeliste, an der das entsprechende Element steht, ermöglicht den sofortigen Zugriff zur Gruppenliste bzw. zur komprimierten Datenfolgeliste.

Die Entstehung der reduzierten Gruppenliste I gemäß Tabelle 6 und der zugehörigen komprimierten Liste II gemäß Tabelle 7 läßt sich wiederum leicht anhand der Verfahrensschritte gemäß Anspruch 15 verfolgen. Gleiches gilt für die reduzierte Gruppenliste II gemäß Tabelle 8, für die die Verfahrensschritte im Anspruch 21 aufgeführt sind. Die zugehörige Zeichenliste ist die Liste gemäß Tabelle 4. Die jeweiligen Verfahrensschritte für die Dekompression finden sich in den Ansprüchen 16 bzw. 22. Die Klammerangaben stellen wiederum die zusätzlichen Weiterbildungen dar.

### Tabelle 4

#### Zeichenliste

| Index | Element | Stelle der Gruppenliste |
|---|---|---|
| 1 | A | 100 |
| 2 | B | 101 |
| 3 | E | 104 |
| 4 | R | 107 |
| 5 | * | 110 |
| 6 | N | 113 |
| 7 | D | 116 |

### Tabelle 5

#### Gruppenliste II

| Index | Eintrag |
|---|---|
| 100 | 1 |
| 101 | 2 |
| 102 | 103 |
| 103 | 102 |
| 104 | 3 |
| 105 | 106 |
| 106 | 105 (112) |
| 107 | 4 |
| 108 | 109 |
| 109 | 108 |
| 110 | 5 (119) |
| 111 | 1000 |
| 112 | 105 |
| 113 | 6 |
| 114 | 115 |
| 115 | 114 |
| 116 | 7 |
| 117 | 118 |
| 118 | 117 |
| 119 | 5 |
| 120 | 1001 |

### Tabelle 6

#### Reduzierte Gruppenliste I

| Index | Eintrag |
|---|---|
| 100 | A |
| 101 | B |
| 102 | 102 |
| 103 | E |
| 104 | 104 (109) |
| 105 | R |
| 106 | 106 |
| 107 | * (114) |
| 108 | 1000 |
| 109 | 109 (104) |
| 110 | N |
| 111 | 111 |
| 112 | O |
| 113 | 113 |
| 114 | * |
| 115 | 1001 |

### Tabelle 7

#### Komprimierte Liste II

| Index | Eintrag |
|---|---|
| 1000 | 108 |
| 1001 | 115 |

Tabelle 8

Reduzierte Gruppenliste II

| Index | Eintrag |
|-------|---------|
| 100 | 1 |
| 101 | 2 |
| 102 | 102 |
| 103 | 3 |
| 104 | 104 (109) |
| 105 | 4 |
| 106 | 106 |
| 107 | 5 (114) |
| 108 | 1000 |
| 109 | 109 (104) |
| 110 | 6 |
| 111 | 111 |
| 112 | 7 |
| 113 | 113 |
| 114 | 5 |
| 115 | 1001 |

Für die Weiterbildung der Erfindung, die sich auf Anwendungen bei der automatischen Verknüpfung von Folgen serieller Datenelemente beziehen, sei folgendes Beispiel gegeben.

Es werden drei Folgen serieller Datenelemente betrachtet, deren Teilfolgen beispielsweise Punkte (Bahnhöfe) auf drei Verbindungsstrecken darstellen. Die drei Folgen selbst bezeichnen jeweils bestimmte Verbindungen auf den Strecken.

Abweichend von den vorhergehenden Beispielen werden die Teilfolgen, also die Punkte hier zur Vereinfachung durch Buchstaben dargestellt. Die komprimierten Datenfolgelisten für die drei Folgen lauten:

A B C D E     F G C H I     J K L H M

Als Knotenpunkte für die Verknüpfungen zwischen den drei Folgen ergibt sich dann folgende Liste, wobei jeder einzelne Wert durch den Anfangspunkt einer Verbindung, den bzw.
die Knotenpunkte und den Endpunkt der Verbindung bezeichnet
wird:

A C F / A C G / A C H / A C I / B C F / ... / A C H J /
A C H K / ...

Als Teilverbindungen für die Verbindung A/J ergeben sich:

AC - C H - H J.

## BLUMBACH · WESER · BERGEN · KRAMER
## ZWIRNER · HOFFMANN
### PATENTANWÄLTE IN MÜNCHEN UND WIESBADEN

Patentconsult Radeckestraße 43 8000 München 60 Telefon (089) 883603/883604 Telex 05-212313 Telegramme Patentconsult
Patentconsult Sonnenberger Straße 43 6200 Wiesbaden Telefon (06121) 562943/561998 Telex 04-186237 Telegramme Patentconsult

Dr. Karl Eckhart Heinz
Niebuhrstraße 49
5300 Bonn 1

## Patentansprüche

1. Verfahren zur Kompression redundanter Folgen serieller Datenelemente, die in Teilfolgen mit je beliebiger Anzahl von Datenelementen und einem Schlußzeichen unterteilt sind, gekennzeichnet durch die Verfahrensschritte:

I. für die erste Teilfolge

1) das erste und zweite Element (A, B) werden zu einer ersten Zweiergruppe (AB) zusammengefaßt, die eine Codebezeichnung (102) erhält und zusammen mit dieser in einer Gruppenliste gespeichert wird;

2) die Codebezeichnung (102) der ersten Zweiergruppe und das dritte Element (E) werden zu einer weiteren Zweiergruppe zusammengefaßt, die eine Codebezeichnung (105) erhält und zusammen mit dieser in der Gruppenliste gespeichert wird;

3) die Codebezeichnung (105) der weiteren Zweiergruppe und das folgende Element werden zu einer weiteren Zweiergruppe zusammengefaßt, die eine Codebezeichnung (108) erhält usw., bis zum Schlußzeichen (*), das mit der Codebezeichnung (108) der vorhergehenden Zweiergruppe eine letzte Zweiergruppe bildet, die wiederum eine Codebezeichnung (111)

München: R. Kramer Dipl.-Ing. · W. Weser Dipl.-Phys. Dr. rer. nat. · E. Hoffmann Dipl.-Ing.
Wiesbaden: P. G. Blumbach Dipl.-Ing. · P. Bergen Prof. Dr. jur. Dipl.-Ing., Pat.-Ass., Pat.-Anw. bis 1979 · G. Zwirner Dipl.-Ing. Dipl.-W.-Ing.

erhält und zusammen mit dieser in der Gruppenliste gespeichert wird;

II. <u>für die zweite und die weiteren Teilfolgen</u>

4) es werden die Schritte 1) bis 3) wiederholt, wobei jedoch
geprüft wird, ob die erste Zweiergruppe (AB) mit der
ersten Zweiergruppe (AB) der ersten Teilfolge bzw.
einer der weiteren Teilfolgen übereinstimmt;
wenn nein, wird wie bei der ersten Teilfolge verfahren;
wenn ja, wird die Codebezeichnung (102) der ersten Zweiergruppe mit dem dritten Element (E) verknüpft und wiederum
geprüft, ob diese weitere Zweiergruppe mit der weiteren
Zweiergruppe der ersten bzw. weiteren Teilfolge übereinstimmt;
wenn ja, wird die Codebezeichnung (105) der weiteren
Zweiergruppe mit dem folgenden Element (N) verknüpft usw.,
bis zum Ende der Übereinstimmung der Zweiergruppen;

5) die Codebezeichnung (105) der letzten übereinstimmenden
Zweiergruppe wird in der Gruppenliste gespeichert, und
gegebenenfalls weitere Elemente (N, D, *) werden gemäß
Schritt 3) verarbeitet;

6) in einer komprimierten Datenfolgeliste wird jede Teilfolge durch die Codebezeichnung ihrer letzten Zweiergruppe identifiziert.


2. Verfahren zur Dekompression einer gemäß Anspruch 1 komprimierten Folge serieller Datenelemente,
gekennzeichnet durch die Verfahrensschritte:

1) Aufruf der ersten Codebezeichnung (111) in der komprimierten Datenfolgeliste;

2) Prüfen, ob das erste Glied (108) der durch die Codebezeichnung (111) identifizierten Zweiergruppe (108, *) eine Codebezeichnung (108) oder ein Element ist; wenn ein Element vorliegt, Ausgabe der Zweiergruppe und Übergang zu Schritt 5); wenn eine Codebezeichnung (108) vorliegt, Übergang zu Schritt 3);

3) Wiederholen der Prüfung des Schrittes 3) für die durch die Codebezeichnung bezeichnete Zweiergruppe (105, R) bis zu einer Anfangsgruppe (A, B), deren erstes Glied (A) ein Element ist;

4) Ausgabe der Zweiergruppe (A, B) und des zweiten Gliedes (E, R, *) aller vorher durchlaufenen Zweiergruppen;

5) Wiederholen des Verfahrens für alle nachfolgenden Codebezeichnungen in der komprimierten Datenfolgeliste.

3. Verfahren zur Kompression nach Anspruch 1, gekennzeichnet durch folgende Verfahrensschritte:

   I. für die erste Teilfolge

1) Eintrag des ersten Elements (A) an der ersten Stelle (100) einer Gruppe (100 bis 102) in der Gruppenliste mit dreistelligen Gruppen (100 bis 102; 103 bis 105...); wobei der Index (102, 105, 108...) der dritten Stelle jeder Gruppe die Codebezeichnung dieser Gruppe ist;

2) Eintrag des zweiten Elements an der zweiten Stelle (101) der Gruppe(100 bis 102) der Gruppenliste;

3) Eintrag des Index (102) der dritten Gruppenstelle als Codebezeichnung an der ersten Stelle (103) einer weiteren Gruppe (103 bis 105) der Gruppenliste;

4) Eintrag des Index (103) der ersten Stelle der weiteren Gruppe gemäß Verfahrensschritt 3) an der dritten Stelle (103) der vorhergehenden Gruppe;

5) Eintrag des folgenden Elements (E) an der zweiten Stelle (104) einer weiteren Gruppe (103 bis 105) der Gruppenliste;

6) Eintrag des Index (105) der dritten Gruppenstelle als Codebezeichnung an der ersten Stelle (106) einer weiteren Gruppe (106 bzw. 108) der Gruppenliste;

7) Eintrag des Index (106) der ersten Stelle der weiteren Gruppe gemäß Verfahrensschritt 6) an der dritten Stelle (105) der vorhergehenden Gruppe;

8) Wiederholen der Verfahrensschritte 5) bis 7) für alle folgenden Elemente (E, R, *) der Teilfolge einschließlich des Schlußzeichens (*);

9) Eintragen des Index (111) für die dritte Stelle der Gruppe (109 bis 111), die an der zweiten Stelle (110) das Schlußzeichen enthält, an einer ersten Stelle (1000) einer komprimierten Datenfolgenliste und Übernahme des Index (1000) dieser Stelle in die dritte Stelle (111) der Schlußzeichengruppe (109 bis 111);

## II. für die weiteren Teilfolgen

10) Prüfen, ob eine Gruppe (100 bis 102) in der Gruppenliste vorhanden ist, die an der ersten Stelle (100) das erste Element (A $\triangleq$ 1) und an der zweiten Stelle (101) das zweite Element (B $\triangleq$ 2) enthält;

wenn nein, Übergang zu Schritt 11);

wenn ja, Übergang zu Schritt 12);

11a) Eintrag des ersten und zweiten Elements an der ersten bzw. zweiten Stelle einer weiteren Gruppe in der Gruppenliste;

11b) Durchführen der Verfahrensschritte 3) bis 9);

12) Prüfen, ob der Gruppe (100 bis 102) gemäß 10) eine Gruppe (103 bis 105) folgt, die an zweiter Stelle (104) das folgende Element (E) enthält;

wenn nein, Übergang zu Schritt 13);

wenn ja, Übergang zu Schritt 14);

13) Durchführen von Schritt 6) für die Gruppe gemäß 10) und der Schritte 8) und 9);

14) Prüfen, ob der folgenden Gruppe (103 bis 105) gemäß 20) wiederum eine Gruppe folgt, die an zweiter Stelle das folgende Element (N) enthält;

wenn nein, Übergang zu Schritt 15);

wenn ja, Übergang zu Schritt 16);

15) Durchführen von Schritt 6) und 7) für die folgende Gruppe (103 bis 105) gemäß 20) und der Schritte 8) und 9);

16) Wiederholen von Schritt 14) für die nächstfolgende Gruppe.

4. Verfahren zur Dekompression einer gemäß Anspruch 3 komprimierten Folge, gekennzeichnet durch die Verfahrensschritte:

I

1) Aufruf des ersten Eintrags (111) der komprimierten Datenfolgeliste;

2) Prüfen, ob der Eintrag der Index für die dritte Stelle einer Gruppe in der Gruppenliste ist;

wenn nein, Ausgabe des Eintrags und Übergang zu Schritt 6);

wenn ja, Übergang zu Schritt 3);

3) Prüfen, ob der Eintrag an der ersten Stelle der Gruppe der Index für die dritte Stelle einer vorhergehenden Gruppe in der Gruppenliste ist;

wenn nein, Ausgabe des Eintrags der ersten und zweiten Stelle der Gruppe und Übergang zu Schritt 6);

wenn ja, Übergang zu Schritt 4);

4) Wiederholen der Prüfung des Schrittes 3) für die vorhergehende Gruppe bis zum Erreichen einer Anfangsgruppe in der Gruppenliste, für die der Eintrag an der ersten Stelle ein Element ist;

5) Ausgabe des Eintrags der ersten und zweiten Stelle der Anfangsgruppe und der zweiten Stelle aller vorhergehend durchlaufenen Gruppen einschließlich der Gruppe gemäß Schritt 2);

6) Wiederholen des Verfahrens für den nächsten Eintrag der komprimierten Datenfolgeliste.

5. Verfahren zur Kompression nach Anspruch 3,
dadurch gekennzeichnet, daß nach dem Eintrag eines folgenden Elements (*) an der zweiten Stelle (119) einer weiteren Gruppe (118 bis 120) geprüft wird, ob dieses Element bereits an der ersten oder
zweiten Stelle (110) einer vorhergehenden Gruppe (109 bis 111) eingetragen ist und, wenn ja, Ersatz des vorhergehenden Eintrags durch den Index (119) des Eintrags in der weiteren Gruppe.

6. Verfahren zur Dekompression einer gemäß Anspruch 5 komprimierten Folge,
dadurch gekennzeichnet, daß vor Ausgabe des Eintrags (119) der zweiten Stelle (110) eine Gruppe (109 bis 111) geprüft wird, ob der Eintrag ein Index (119) für die erste oder/ zweite Stelle einer nachfolgenden Gruppe (118 bis 120) ist, und wenn ja, daß die Prüfung für den Eintrag (*) an der ersten oder/ zweiten Stelle (119) der nachfolgenden Gruppe und gegebenenfalls weiterer Gruppen wiederholt wird bis zur Erreichung eines Elements (*) und Ausgabe dieses Elements.

7. Verfahren zur Kompression nach Anspruch 3 oder 5,
dadurch gekennzeichnet, daß nach dem Eintrag des Index (105) der dritten Stelle einer Gruppe (103 bis 105) an der ersten Stelle (112) einer weiteren Gruppe (112 bis 114) geprüft wird, ob dieser Index (105) bereits an der ersten Stelle (106) einer vorhergehenden Gruppe (106 bis 108) eingetragen ist, und wenn ja, Ersatz des vorhergehenden Eintrags durch den Index (112) des Eintrags in der weiteren Gruppe.

8. Verfahren zur Dekompression einer gemäß Anspruch 7 komprimierten Folge,
dadurch gekennzeichnet, daß vor Durchführen des Schritts 3) gemäß Anspruch 4 geprüft wird, ob der Eintrag (112) an der ersten Stelle (106) einer Gruppe (106 bis 108) der Index (112) für die erste Stelle einer nachfolgenden Gruppe (112 bis 114) ist, und wenn ja, daß die Prüfung für den Eintrag (105) an der ersten Stelle (112) wiederholt wird, bis zur Erreichung eines Index (105) für die dritte Stelle einer vorhergehenden Gruppe.

9. Verfahren zur Kompression nach Anspruch 1, gekennzeichnet durch folgende Verfahrensschritte:

### I. für die erste Teilfolge

1) Eintrag des ersten Elements (A) an einer Stelle (1) einer ersten Rubrik einer Zeichenliste;

2) Eintrag des Zeichenlistenindex (1) für das erste Element (A) an der ersten Stelle (100) einer Gruppe (100 bis 102) in einer Gruppenliste mit dreistelligen Gruppen (100 bis 102; 103 bis 105 ...),
wobei der Index (102, 105, 108 ...) der dritten Stelle jeder Gruppe die Codebezeichnung dieser Gruppe ist;

3) Eintrag des Indexes (100) der ersten Gruppenstelle gemäß 2) in die zweite Rubrik der Zeichenliste an der Stelle gemäß 1);

4) Prüfen, ob das zweite Element (B) schon in der ersten Rubrik der Zeichenliste vorhanden ist, und, wenn nein, Eintrag des zweiten Elements (B) an der folgenden Stelle der ersten Rubrik der Zeichenliste;

5) Eintrag des Zeichenlistenindex (2) für das zweite Element an der zweiten Stelle (101) der Gruppe (100 bis 102) der Gruppenliste;

6) Eintrag des Index (101) der zweiten Gruppenstelle in die zweite Rubrik der Zeichenliste an der Stelle gemäß 4);

7) Eintrag des Index (102) der dritten Gruppenstelle als Codebezeichnung der Gruppe an der ersten Stelle (103) einer weiteren Gruppe (103 bis 105) der Gruppenliste;

8) Eintrag des Index (103) der ersten Stelle der weiteren Gruppe gemäß Verfahrensschritt 7) an der dritten Stelle (103) der vorhergehenden Gruppe;

9) Prüfen, ob das folgende Element (E, R, *) schon in der ersten Rubrik der Zeichenliste vorhanden ist, und, wenn nein, Eintrag an der folgenden Stelle der ersten Rubrik der Zeichenliste;

10) Eintrag des Zeichenlistenindex (3) für das folgende Element (E) an der zweiten Stelle (104) einer weiteren Gruppe (103 bis 105) der Gruppenliste;

11) Eintrag des Index (104) der zweiten Gruppenstelle in die zweite Rubrik in der Zeichenliste an der Stelle gemäß 9);

12) Eintrag des Index (105) der dritten Gruppenstelle als Codebezeichnung an der ersten Stelle (106) einer weiteren Gruppe (106 bzw. 108) der Gruppenliste;

13) Eintrag des Indexes (106) der ersten Stelle der weiteren Gruppe gemäß Verfahrensschritt 12) an der dritten Stelle (105) der vorhergehenden Gruppe;

14) Wiederholen der Verfahrensschritte 9) bis 13) für alle folgenden Elemente (E, R, *) der Teilfolge einschließlich des Schlußzeichens (*);

15) Eintragen des Gruppenlistenindex (111) für die dritte Stelle der Gruppen (109 bis 111), die an der zweiten Stelle (110) das Schlußzeichen enthält, an einer ersten Stelle (1000) einer komprimierten Datenfolgeliste und Übernahme des Index (1000) dieser Stelle in die dritte Stelle (111) der Schlußzeichengruppe (109 bis 111);

### II. für die weiteren Teilfolgen

16) Prüfen, ob das erste Element (A) der folgenden Teilfolge (ABEND*) schon in der ersten Rubrik der Zeichenliste vorhanden ist, und wenn nein, Eintrag an der folgenden Stelle der ersten Rubrik;

17) Wiederholen von 16) für das zweite Element (B) der folgenden Teilfolge;

18) Prüfen, ob eine Gruppe (100 bis 102) in der Gruppenliste vorhanden ist, die an der ersten Stelle (100) den Zeichenlistenindex (1) des ersten Elements (A) und an der zweiten Stelle (101) den Zeichenlistenindex (2) des zweiten Elements (B) enthält;

wenn nein, Übergang zu Schritt 19);

wenn ja, Übergang zu Schritt 20);

19a) Eintrag des Zeichenlistenindex für das erste und zweite Element an der ersten bzw. zweiten Stelle einer weiteren Gruppe in der Gruppenliste;

19b) Eintrag des Gruppenlistenindex für das erste und zweite Element in die zweite Rubrik der Zeichenliste an der Stelle gemäß 16) bzw. 17), falls dort noch kein Gruppenlisteneintrag vorliegt;

19c) Durchführen der Verfahrensschritte 7) bis 15);

20) Prüfen, ob der Gruppe (100 bis 102) gemäß 18) eine Gruppe (103 bis 105) folgt, die an zweiter Stelle (104) den Zeichenlistenindex (3) des folgenden Elements (E) enthält; wenn nein, Übergang zu Schritt 21), wenn ja, Übergang zu Schritt 22);

21) Durchführen von Schritt 12) und 13) für die Gruppe gemäß 18) und der Schritte 14) und 15);

22) Prüfen, ob der folgenden Gruppe (103 bis 105) gemäß 20) wiederum eine Gruppe folgt, die an zweiter Stelle den Zeichenlistenindex des folgenden Elements (N) enthält; wenn nein, Übergang zu Schritt 23); wenn ja, Übergang zu Schritt 24);

23) Durchführen von Schritt 12) und 13) für die folgende Gruppe (103 bis 105) gemäß 20) und der Schritte 14) und 15);

24) Wiederholen von Schritt 22) für die nächstfolgende Gruppe .

10. Verfahren zur Dekompression einer gemäß Anspruch 9 komprimierten Folge serieller Datenelemente, gekennzeichnet durch die Verfahrensschritte:

I

1) Aufruf des ersten Eintrags (111) der komprimierten Datenfolgeliste;

2) Prüfen, ob der Eintrag der Index für die dritte Stelle einer Gruppe in der Gruppenliste ist; wenn nein, Ausgabe des Eintrags und Übergang zu Schritt 6); wenn ja, Übergang zu Schritt 3);

3) Prüfen, ob der Eintrag an der ersten Stelle der Gruppe der Index für die dritte Stelle einer vorhergehenden Gruppe in der Gruppenliste ist; wenn nein, Ausgabe des Eintrags der ersten und zweiten Stelle der Gruppe und Übergang zu Schritt 6); wenn ja, Übergang zu Schritt 4);

4) Wiederholen der Prüfung des Schrittes 3) für die vorhergehende Gruppe bis zum Erreichen einer Anfangsgruppe in der Gruppenliste, für die der Eintrag an der ersten Stelle der Zeichenlistenindex eines Elements ist;

5) Ausgat des Eintrags der ersten und zweiten Stelle der Anfangsgruppe und der zweiten Stelle aller vorhergehend durchlaufenen Gruppen einschließlich der Gruppe gemäß Schritt 2);

6) Wiederholen des Verfahrens für den nächsten Eintrag der komprimierten Datenfolgeliste,

7) Übersetzen der angegebenen Zeichenlisten-indices.

11. Verfahren zur Kompression nach Anspruch 9, dadurch gekennzeichnet, daß nach dem Eintrag des Zeichenlistenindex (5) für ein folgendes Element (*) an der zweiten Stelle (119) einer weiteren Gruppe (118 bis 120) gemäß Schritt 10) geprüft wird, ob der Zeichenlistenindex (5) beersten oder, reits an der/zweiten Stelle (110) einer vorhergehenden Gruppe (109 bis 111) eingetragen ist, und wenn ja, Ersatz des vorhergehenden Eintrags durch den Gruppenlistenindex (119) des Eintrags in der weiteren Gruppe.

12. Verfahren zur Dekompression einer gemäß Anspruch 11 komprimierten Folge,

dadurch gekennzeichnet, daß vor Ausgabe des Eintrags (119) der zweiten Stelle (110) eine Gruppe (109 bis 111) der Gruppenliste geprüft wird, ob der Eintrag ein Gruppenlistenindex (119) für die erste oder zweite Stelle einer nachfolgenden Gruppe (118 bis 120) ist, und wenn ja, daß die Prüfung für den Eintrag (5) an der ersten oder zweiten Stelle (119) der nachfolgenden Gruppe und ggf. weiterer Gruppen wiederholt wird bis zur Erreichung eines Zeichenlistenindex (5) und Ausgabe dieses Index.

13. Verfahren zur Kompression nach Anspruch 9 oder 11, dadurch gekennzeichnet, daß nach dem Eintrag des Indexes (105) der dritten Gruppenstelle einer Gruppe (103 bis 105) der Gruppenliste an der ersten Stelle (112) einer weiteren Gruppe (112 bis 114) gemäß Schritt 12) geprüft wird, ob dieser Index (105) bereits an der ersten Stelle (106) einer vorhergehenden Gruppe (106 bis 108) eingetragen ist, und wenn ja, Ersatz des vorhergehenden Eintrags durch den Gruppenlistenindex (112) des Eintrags in der weiteren Gruppe.

14. Verfahren zur Dekompression einer gemäß Anspruch 13 komprimierten Folge, dadurch gekennzeichnet, daß vor Durchführen des Schritts 3) gemäß Anspruch 10 geprüft wird, ob der Eintrag (112) aus der ersten Stelle (106) einer Gruppe (106 bis 108) der Index (112) für die erste Stelle einer nachfolgenden Gruppe (112 bis 114) ist, und wenn ja, daß die Prüfung für den Eintrag (105) an der ersten Stelle (112) wiederholt wird, bis zur Erreichung eines Index (105) für die dritte Stelle einer vorhergehenden Gruppe.

15. Verfahren zur Kompression nach Anspruch 1, gekennzeichnet durch folgende Verfahrensschritte:

### I. für die erste Teilfolge

1) Eintrag des ersten Elements (A) an der ersten Stelle

(100) einer Gruppe (100 bis 102) in einer Gruppenliste mit zweistelligen Gruppen (100, 101; 10. 103; 104, 105

...), wobei der Index (100, 102, 104...) der ersten Stelle jeder Gruppe die Codebezeichnung für die jeweils unmittelbar vorhergehende Gruppe ist;

2) Eintrag des zweiten Elements an der zweiten Stelle (101) der Gruppe (100, 101) der Gruppenliste;

3) Eintrag des Index (102) der ersten Stelle einer weiteren Gruppe (102, 103) der Gruppenliste an dieser ersten Stelle (102);

4) Eintrag des folgenden Elements (E) an der zweiten Stelle (103) der weiteren Gruppe (102, 103) der Gruppenliste;

5) Eintrag des Index (104) der ersten Stelle (104) einer weiteren Gruppe (104, 105) der Gruppenliste an dieser ersten Stelle (104);

6) Wiederholen der Verfahrensschritte 4) und 5) für alle folgenden Elemente(E, R, *) der Teilfolge einschließlich des Schlußzeichens (*);

7) Eintrag des Index (108) für die erste Stelle (108), die derjenigen Gruppe (106, 107) folgt, welche an der zweiten Stelle (107) das Schlußzeichen (*) enthält, an einer ersten Stelle (1000) einer komprimierten Datenfolgenliste und Übernahme des Index (1000) dieser Stelle in die erste Stelle (108), die der Schlußzeichengruppe (106, 107) folgt;

   II. für die weiteren Teilfolgen

8) Prüfen, ob eine Gruppe (100, 101) in der Gruppenliste vorhanden ist, die an der ersten Stelle (100) das erste Element (A) und an der zweiten Stelle das zweite Element (B) enthält;

   wenn nein, Übergang zu Schritt 9);

   wenn ja, Übergang zu Schritt 10);

9a) Eintrag des ersten und zweiten Elements an der ersten bzw. zweiten Stelle einer weiteren Gruppe in der Gruppenliste;

9b) Durchführen der Verfahrensschritte 3) bis 7);

10) Prüfen, ob der Gruppe (100, 101) gemäß 8) eine Gruppe (102, 103) folgt, die an zweiter Stelle (103) das folgende Element (E) enthält;

   wenn nein, Übergang zu Schritt 11);

   wenn ja, Übergang zu Schritt 12);

11) Durchführen von Schritt 5) für die Gruppe gemäß 8) und der Schritte 6) und 7);

12) Prüfen, ob der folgenden Gruppe (102, 103) gemäß 10) wiederum eine Gruppe (104, 105) folgt, die an zweiter Stelle (105) das folgende Element (N) enthält;

wenn nein, Übergang zu Schritt 13);

wenn ja, Übergang zu Schritt 14);

13) Durchführen von Schritt 5) für die folgende Gruppe (102, 103) gemäß 10) und der Schritte 6) und 7);

14) Wiederholen von Schritt 12) für die nächstfolgende Gruppe.

16. Verfahren zur Dekompression einer gemäß Anspruch 15 komprimierten Folge serieller Datenelemente, gekennzeichnet durch die Verfahrensschritte:

I

1) Aufruf des ersten Eintrags (108) der komprimierten Datenfolgeliste;

2) Prüfen, ob der Eintrag an der ersten Stelle der Gruppe der Index dieser ersten Stelle ist;
   wenn nein, Ausgabe des Eintrags der ersten und zweiten Stelle der Gruppe und Übergang zu Schritt 5);
   wenn ja, Übergang zu Schritt 3);

3) Wiederholen der Prüfung des Schritts 2) für die vorhergehende Gruppe bis zum Erreichen einer Anfangsgruppe in der Gruppenliste, für die der Eintrag an der ersten Stelle ein Element ist;

4) Ausgabe des Eintrags der ersten und zweiten Stelle der Anfangsgruppe und der zweiten Stelle aller vorhergehend durchlaufenen Gruppen einschließlich der Gruppe gemäß Schritt 2);

5) Wiederholen des Verfahrens für den nächsten Eintrag der komprimierten Datenfolgeliste.

17. Verfahren zur Kompression nach Anspruch 15, dadurch gekennzeichnet, daß nach dem Eintrag des folgenden Elements (*) an der zweiten Stelle (114) einer weiteren Gruppe (113, 114) gemäß Schritt 4) geprüft wird, ob das .

Element bereits an der/zweiten Stelle (107) einer vorherersten oder

gehenden Gruppe (106, 107) eingetragen ist, und wenn ja, Ersatz des vorhergehenden Eintrags durch den Index (114) des Eintrags in der weiteren Gruppe.

18. Verfahren zur Dekompression einer gemäß Anspruch 17 komprimierten Folge, dadurch gekennzeichnet, daß vor Ausgabe des Eintrags (114) der zweiten Stelle (107) einer Gruppe (106, 107) der Gruppenliste gemäß Schritt 4) geprüft wird, ob der Eintrag

ein Index (114) für die/zweite Stelle einer nachfolgenden

erste oder

Gruppe (113, 114) ist, und wenn ja, daß die Prüfung für den Eintrag (5) an der /

ersten oder zweiten Stelle (114) der nachfolgenden Gruppe und gegebenenfalls weiterer Gruppen wiederholt wird bis zur Erreichung eines Elements (*) und Ausgabe dieses Elements.

19. Verfahren zur Kompression nach Anspruch 15 oder 17, dadurch gekennzeichnet, daß nach dem Eintrag des Index (104) der ersten Stelle einer Gruppe (104, 105) der Gruppenliste an der ersten Stelle (109) einer weiteren Gruppe (109,110) geprüft wird, ob dieser Index (104) bereits an der ersten Stelle (104) eingetragen ist.

und wenn ja, Ersatz des vorhergehenden Eintrags durch den Index (109) des Eintrags in der weiteren Gruppe.

20. Verfahren zur Dekompression einer gemäß Anspruch 19 komprimierten Folge, dadurch gekennzeichnet, daß vor Durchführung des Schritts 2) gemäß Anspruch 16 geprüft wird, ob der Eintrag (109) an der ersten Stelle (104) einer Gruppe (104, 105) der Index (109) für die erste Stelle einer nachfolgenden Gruppe (109, 110) ist, und wenn ja, daß die Prüfung für den Eintrag an der ersten Stelle wiederholt wird bis zur Erreichung eines Index (104) für die erste Stelle einer vorhergehenden Gruppe (104,105).

21. Verfahren zur Kompression nach Anspruch 1, gekennzeichnet durch folgende Verfahrensschritte:

I. für die erste Teilfolge

1) Eintrag des ersten Elements (A) an einer Stelle (1) einer ersten Rubrik einer Zeichenliste;

2) Eintrag des Zeichenlistenindex (1) für das erste Element (A) an der ersten Stelle (100) einer Gruppe (100 bis 102) in einer Gruppenliste mit zweistelligen Gruppen (100, 101; 102, 103; 104, 105...) wobei der Index (100, 102, 104...) der ersten Stelle jeder Gruppe die Codebezeichnung für die jeweils unmittelbar vorhergehende Gruppe ist;

3) Eintrag des Index (100) der ersten Gruppenstelle gemäß 2) in die zweite Rubrik der Zeichenliste an der Stelle gemäß 1);

4) Prüfen, ob das zweite Element (B) schon in der ersten Rubrik der Zeichenliste vorhanden ist, und wenn nein, Eintrag des zweiten Elements (B) an der folgenden Stelle der ersten Rubrik der Zeichenliste;

5) Eintrag des Zeichenlistenindex (2) für das zweite Element an der zweiten Stelle (101) der Gruppe (100, 101) der Gruppenliste;

6) Eintrag des Index (101) der zweiten Gruppenstelle in die zweite Rubrik der Zeichenliste an der Stelle gemäß 4);

7) Eintrag des Index (102) der ersten Stelle einer weiteren Gruppe (102, 103) der Gruppenliste an dieser ersten Stelle (102);

8) Prüfen, ob das folgende Element (E, R, *) schon in der ersten Rubrik der Zeichenliste vorhanden ist, und wenn nein, Eintrag an der folgenden Stelle der ersten Rubrik der Zeichenliste;

9) Eintrag des Zeichenlistenindex (3) für das folgende Element (E) an der zweiten Stelle (103) der weiteren Gruppe (102, 103) der Gruppenliste;

10) Eintrag des Index (103) der zweiten Gruppenstelle in die zweite Rubrik in der Zeichenliste an der Stelle gemäß 8);

11) Eintrag des Index (104) der ersten Stelle (104) einer weiteren Gruppe (104, 105) der Gruppenliste an dieser ersten Stelle (104);

12) Wiederholen der Verfahrensschritte 8) bis 11) für alle folgenden Elemente (E, R, *) der Teilfolge einschließlich des Schlußzeichens (*);

13) Eintragen des Gruppenlistenindex (108) für die erste Stelle (108), die derjenigen Gruppe (106, 107) folgt, welche an der zweiten Stelle (107) den Zeichenlistenindex (5) des Schlußzeichens (*) enthält, an einer ersten Stelle (1000) einer komprimierten Datenfolgeliste und Übernahme des Index (1000) dieser Stelle in die erste Stelle (108), die der Schlußzeichengruppe (106, 107) folgt;

### II. für die weiteren Teilfolgen

14) Prüfen, ob das erste Element (A) der folgenden Teilfolge (ABEND*) schon in der ersten Rubrik der Zeichenliste vorhanden ist, und wenn nein, Eintrag an der folgenden Stelle der ersten Rubrik;

15) Wiederholen von 14) für das zweite Element (B) der folgenden Teilfolge;

16) Prüfen, ob eine Gruppe (100, 101) in der Gruppenliste vorhanden ist, die an der ersten Stelle (100) den Zeichenlistenindex (1) des ersten Elements (A) und an der zweiten Stelle den Zeichenlistenindex (2) des zweiten Elements (B) enthält;

wenn nein, Übergang zu Schritt 17);

wenn ja, Übergang zu Schritt 18);

17a)Eintrag des Zeichenlistenindex für das erste und zweite Element an der ersten bzw. zweiten Stelle einer weiteren Gruppe in der Gruppenliste;

17b) Eintrag des Gruppenlistenindex für das erste und zweite Element in die zweite Rubrik der Zeichenliste an der Stelle gemäß 14) bzw. 15), falls dort noch kein Gruppenlisteneintrag vorliegt;

17c) Durchführen der Verfahrensschritte 7) bis 13);

18) Prüfen, ob der Gruppe (100, 101) gemäß 16) eine Gruppe (102, 103) folgt, die an zweiter Stelle (103) den Zeichenlistenindex (3) des folgenden Elements (E) enthält; wenn nein, Übergang zu Schritt 19), wenn ja, Übergang zu Schritt 20);

19) Durchführen von Schritt 11) für die Gruppe gemäß 16) und der Schritte 12) und 13);

20) Prüfen, ob der folgenden Gruppe (102, 103) gemäß 18) wiederum eine Gruppe (104, 105) folgt, die an zweiter Stelle (105) den Zeichenlistenindex (6) des folgenden Elements (N) enthält; wenn nein, Übergang zu Schritt 21); wenn ja, Übergang zu Schritt 22);

21) Durchführen von Schritt 11) für die folgende Gruppe (102, 103) gemäß 18) und der Schritte 12) und 13);

22) Wiederholen von Schritt 20) für die nächstfolgende Gruppe.

22. Verfahren zur Dekompression ein-er gemäß Anspruch 21 komprimierten Folge serieller Datenelemente, gekennzeichnet durch die Verfahrensschritte:

I

1) Aufruf des ersten Eintrags (108) der komprimierten Datenfolgeliste;

BAD ORIGINAL

2) Prüfen, ob der Eintrag an der ersten Stelle der Gruppe

. der Index dieser ersten Stelle ist;

wenn nein, Ausgabe des Eintrags der ersten und zweiten Stelle der Gruppe und Übergang zu Schritt 5);

wenn ja, Übergang zu Schritt 3);

3) Wiederholen der Prüfung des Schritts 2) für die vorhergehende Gruppe bis zum Erreichen einer Anfangsgruppe in der Gruppenliste, für die der Eintrag an der ersten Stelle der Zeichenlistenindex eines Elements ist;

4) Ausgabe des Eintrags der ersten und zweiten Stelle der Anfangsgruppe und der zweiten Stelle aller vorhergehend durchlaufenen Gruppen einschließlich der Gruppe gemäß Schritt 2);

5) Wiederholen des Verfahrens für den nächsten Eintrag der komprimierten Datenfolgeliste;

6) Übersetzen der ausgegebenen Zeichenlistenindices in die Datenelemente mittels der Zeichenliste.

23. Verfahren zur Kompression nach Anspruch 21, dadurch gekennzeichnet, daß nach dem Eintrag des Zeichenlistenindex (5) für ein folgendes Element (*) an der zweiten Stelle (114) einer weiteren Gruppe (113, 114) gemäß Schritt 9) geprüft wird, ob der Zeichenlistenindex (5) bereits an

der/zweiten Stelle (107) einer vorhergehenden Gruppe (106, 107)
ersten oder
wingetragen ist, und wenn ja, Ersatz des vorhergehenden Eintrags durch den Gruppenlistenindex (114) des Eintrags in der weiteren Gruppe.

24. Verfahren zur Dekompression einer gemäß Anspruch 23 komprimierten Folge, dadurch gekennzeichnet, daß vor Ausgabe des Eintrags (114) der zweiten Stelle (107) einer Gruppe (106, 107) der Gruppenliste gemäß Schritt 4) geprüft wird, ob der Eintrag ein

Gruppenlistenindex (114) für die/zweite Stelle einer nacherste oder

folgenden Gruppe (113, 114) ist, und wenn ja, daß die Prüfung für den Eintrag (5) an der/zweiten Stelle (114) der
ersten oder

nachfolgenden Gruppe und ggf. weiterer Gruppen wiederholt wird bis zur Erreichung eines Zeichenlistenindex (5) und Ausgabe dieses Index.

25. Verfahren zur Kompression nach Anspruch 21 oder 23, dadurch gekennzeichnet, daß nach dem Eintrag des Index (104) der ersten Stelle einer Gruppe (104, 105) der Gruppenliste an der ersten Stelle (109) einer weiteren Gruppe (109, 110) gemäß Schritt 11) geprüft wird, ob dieser Index (104) bereits an der ersten Stelle (104) eingetragen ist, und wenn ja, Ersatz des vorhergehenden Eintrags durch den Gruppenlistenindex (109) des Eintrags in der weiteren Gruppe.

26. Verfahren zur Dekompression einer gemäß Anspruch 25 komprimierten Folge, dadurch gekennzeichnet, daß vor Durchführung des Schritts 2) geprüft wird, ob der Eintrag (109) an der ersten Stelle (104) einer Gruppe (104, 105) der Index (109) für die erste Stelle einer nachfolgenden Gruppe (109, 110) ist, und wenn ja, daß die Prüfung für den Eintrag an der ersten Stelle wiederholt wird bis zur Erreichung eines Index (104) für die erste Stelle einer vorhergehenden Gruppe (104, 105).

27. Verfahren nach einem der vorhergehenden Ansprüche, dadurch gekennzeichnet, daß nach Eintrag einer Codebezeichnung in die komprimierte Datenfolgeliste geprüft wird, ob diese Codebezeichnung bereits an einer vorhergehenden Stelle eingetragen ist, und wenn ja, Ersatz des vorhergehenden Eintrags durch den Index des gerade durchgeführten Eintrags.

28. Verfahren nach einem der vorhergehenden Ansprüche für zeilenmäßig unterteilte Texte, deren Buchstaben, Zeichen und Zwischenräume die Elemente und deren Wörter die Teilfolgen darstellen, wobei die Zeilen je eine vorgegebene Maximalzahl von Wörtern und/oder eine vorgegebene Maximalzahl von Elementen besitzen,
dadurch gekennzeichnet, daß zur Kennzeichnung der Zeilensprünge jeweils der Codebezeichnung der das letzte Element einer Zeile enthaltenden Gruppe ein negatives Vorzeichen zugeordnet wird.

29. Verfahren nach einem der vorhergehenden Ansprüche, dadurch gekennzeichnet, daß die zur Ablage der Listen verwendeten Speicher sich sequentiell aneinander anschließen und daß Verweise in den Listen, die zu einer Stelle jenseits des unmittelbar folgenden Speichers oder bei einem Verweis auf eine höhere Stelle des unmittelbar folgenden Speichers führen, mit einer Kennzeichnung versehen werden.

30. Anwendung des Verfahrens nach einem der vorhergehenden Ansprüche zur automatischen Verknüpfung von Folgen serieller Datenelemente, dadurch gekennzeichnet, daß die Knotenpunkte (C, H) der Verknüpfung durch identische Teilfolgen gebildet werden.

31. Anwendung nach Anspruch 30, dadurch gekennzeichnet, daß zur Herstellung einer Verbindung zwischen einem Anfangspunkt, der sich in einer ersten Folge befindet und einem Zielpunkt, der sich in einer zweiten Folge befindet, eine identische Teilfolge in den komprimierten Datenfolgelisten der beiden Folgen gesucht wird.

32. Anwendung nach Anspruch 30, dadurch gekennzeichnet, daß zur Herstellung einer Verbindung zwischen einem Ausgangspunkt (A), der sich in einer ersten Folge (A B C D E) befindet, und einem Zielpunkt (J), der sich in einer nicht direkt mit der ersten Folge verknüpften zweiten Folge (J K L H M) befindet, die komprimierte Datenfolgeliste (A B C D E, J K L H M) der ersten und der zweiten Folge je mit den komprimierten Datenfolgelisten (F G C H I) weiterer Folgen verglichen werden, um einen geschlossenen Verbindungsweg (A C, C H, H J) über identische Teilfolgen (C, H) von je zwei direkt miteinander verknüpften Folgen zu finden.

33. Anwendung nach einem der Ansprüche 30 bis 32, dadurch gekennzeichnet, daß die Knotenpunkte in einer gesonderten Liste gespeichert sind.

Europäisches
Patentamt

**EUROPÄISCHER RECHERCHENBERICHT**

Nummer der Anmeldung

EP 82 10 3690

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl. ³) |
|---|---|---|---|
| A | US-A-4 054 951 (JACKSON) *Spalte 3, Zeilen 3-25; Spalte 5, Zeile 12 - Spalte 6, Zeile 32; Spalte 7, Zeilen 1-11; Figur 3* & DE - A - 2 723 523 | 1,2 | G 06 F 5/00 H 04 L 25/16 |
| A | US-A-3 490 690 (APPLE) *Spalte 5, Zeile 22 - Spalte 7, Zeile 56* & DE - A - 1 499 225 | 1,2 | |
| A | IEEE TRANSACTIONS ON COMPUTERS, Band C-26, Nr. 5, Mai 1977, Seiten 425-434, New York (USA); A.N.C.KANG et al.: "Storage reduction through minimal spanning trees and spanning forests". *Seite 425, linke Spalte, Absatz 9 - rechte Spalte, Absatz 5* | 1 | |
| A | DE-A-2 336 180 (IBM) *Seite 5, Absatz 3 - Seite 6, Absatz 2* | 1,2 | |
| A | FR-A-2 295 500 (IBM) *Seite 4, Zeile 39 - Seite 6, Zeile 2; Figur 1* & DE - A - 2 460 147 | 1 | |

RECHERCHIERTE SACHGEBIETE (Int. Cl. ³)

H 04 B 1/66
H 04 L 25/16
G 06 F 5/00
G 06 F 15/74
H 04 N 1/41

Der vorliegende Recherchenbericht wurde für alle Patentansprüche erstellt.

| Recherchenort DEN HAAG | Abschlußdatum der Recherche 18-08-1982 | Prüfer STRASSEN TH.W. |
|---|---|---|

KATEGORIE DER GENANNTEN DOKUMENTEN
X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur
T : der Erfindung zugrunde liegende Theorien oder Grundsätze

E : älteres Patentdokument, das jedoch erst am oder nach dem Anmeldedatum veröffentlicht worden ist
D : in der Anmeldung angeführtes Dokument
L : aus andern Gründen angeführtes Dokument

& : Mitglied der gleichen Patentfamilie, übereinstimmendes Dokument

EPA Form 1503. 03.82